**Europäisches Patentamt**

**European Patent Office**

**Office européen des brevets**

(19)

(11) Veröffentlichungsnummer : **0 167 007**
**B1**

(12) **EUROPÄISCHE PATENTSCHRIFT**

(45) Veröffentlichungstag der Patentschrift :
24.01.90

(51) Int. Cl.⁵ : **H 03 C   1/54**

(21) Anmeldenummer : **85106992.2**

(22) Anmeldetag : **05.06.85**

(54) Oszillator-Mischerschaltung.

(30) Priorität : 07.06.84 DE 3421278

(43) Veröffentlichungstag der Anmeldung :
08.01.86 Patentblatt 86/02

(45) Bekanntmachung des Hinweises auf die Patenterteilung : 24.01.90 Patentblatt 90/04

(84) Benannte Vertragsstaaten :
AT CH DE FR GB IT LI NL

(56) Entgegenhaltungen :
EP–A– 0 051 179
EP–A– 0 073 929
FR–A– 2 330 201
ELECTRONICS INTERNATIONAL, Band 54, Nr. 26, 29.
Dezember 1981, Seiten 76-78, New York, US; B.
SCOTT et al.: "Linear one-chip modulator eases TV
circuit design"
ELEKTOR, Band 9, Nr. 2, Februar 1983, Seiten 2-27 - 2-
31, Canterburry, Kent, GB; "VAM - video/audio modulator"

(73) Patentinhaber : Siemens Aktiengesellschaft
Wittelsbacherplatz 2
D-8000 München 2 (DE)

(72) Erfinder : Fenk, Josef, Dipl.-Ing.
Deutenhauserstrasse 10
D-8057 Eching/Ottenburg (DE)

## Beschreibung

Die Erfindung betrifft eine Oszillator-Mischerschaltung eines integrierten Modulators nach dem Oberbegriff des Patentanspruchs 1.

Ein integrierter Modulatorbaustein ist aus der vorläufigen IC-Spezifikation des LM 2 889 TV Video Modulators der Fa. National Semiconductor, April 1983 bekannt. Der integrierte Schaltkreis eignet sich nur für das VHF-Fernsehband und verwendet zwei völlig getrennte Mischer- und Oszillatorschaltungen zur Abstimmung auf zwei Fernsehkanäle. Der integrierte Baustein selbst enthält im wesentlichen aktive Kreise, die durch eine Beschaltung mit passiven, schwer integrierbaren Elementen, d. h. Induktivitäten, Kapazitäten und Widerständen die Oszillatorfrequenz bestimmen (Siehe auch EP-A-0 051 179).

Dieser integrierte TV Modulator benötigt einen erheblichen Schaltungsaufwand im Oszillator- und Mischerteil, wobei trotzdem die für den Einsatz im UHF-Bereich erforderliche Isolation des Video- und Tonsignals gegenüber der Oszillatorstufe nicht ausreicht.

Der vorliegenden Erfindung liegt die Aufgabe zugrunde, einen einen geringen Schaltungsaufwand erfordernden Oszillator- und Mischerteil eines integrierten Modulators anzugeben, der durch eine Beschaltung des Ozillatorteils mit frequenzbestimmenden passiven Kreisen sowohl für UHF — als auch Mehrkanal — VHF -Betrieb auslegbar ist.

Diese Aufgabe wird bei einer Schaltung der eingangs erwähnten Art erfindungsgemäß durch die Merkmale des kennzeichnenden Teils des Patentanspruchs 1 gelöst.

Ausgestaltungen des Erfindungsgedankens sind in Unteransprüchen gekennzeichnet.

Die Erfindung wird nachfolgend anhand dreier Figuren der Zeichnung näher erläutert.

Es zeigt :

Fig. 1 ein Blockschaltbild einer erfindungsgemäßen Schaltung des Oszillator- und Mischerteils eines integrierten Modulatorbausteins,

Fig. 2 ein Ausführungsbeispiel einer Koppelkapazität zwischen Oszillator- und Mischerteil und

Fig. 3 ein Ausführungsbeispiel von Ausgangsanschlüssen zwischen dem aktiven Oszillatorkreis und den frequenzbestimmenden passiven Kreisen sowie der Ausgangsanschlüsse des Mischers.

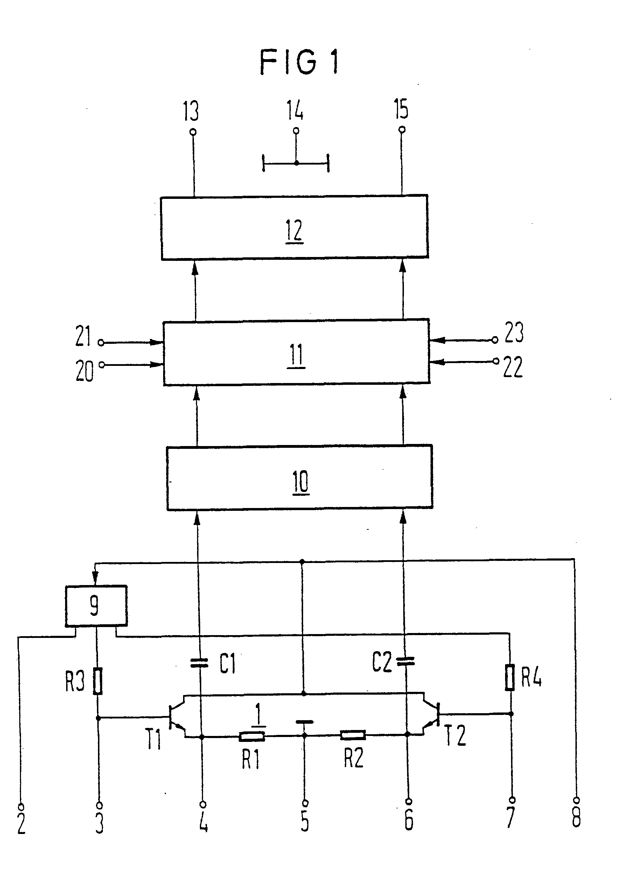

Bei dem in Fig. 1 dargestellten Blockschaltbild einer erfindungsgemäßen Schaltung des Oszillator- und Mischerteils dient die Klemme 8 zum Anschluß der positiven Versorgungsspannung für den integrierten Modulatorbaustein, die auf den Eingang einer Spannungsstabilisierungsstufe 9 geführt ist. In der Spannungsstabilisierungsstufe 9 wird eine Referenzspannung erzeugt, die an der Klemme 2 des Modulatorbausteins abgegriffen werden kann. Die beiden anderen Ausgänge der an sich bekannten Spannungsstabilisierungsstufe 9 sind über die beiden Widerstände R3 bzw. R4 zu je zwei Knoten geführt, die mit der Anschlußklemme 3 des Modulatorbausteins und der Basis des Transistors T1 des aktiven Oszillatorteils 1 bzw. der Anschlußklemme 7 des Modulatorbausteins und der Basis des Transistors T2 des aktiven Oszillatorteils 1 verbunden sind. Die beiden Kollektoren der Transistoren T1 und T2 des aktiven Oszillatorteils 1 sind direkt miteinander verbunden und liegen über die Anschlußklemme 8 des Modulatorbausteins an der positiven Versorgungsspannung für die Schaltung. Der Emitter des Transistors T1 des aktiven Oszillatorteils 1 des Bausteins liegt an der Anschlußklemme 4 und über den Widerstand R1 an der Anschlußklemme 5 des Bausteins, die gleichzeitig Bezugspotential führt. Der Emitter des Transistors T2 des aktiven Oszillatorteils 1 liegt an der Anschlußklemme 6 des integrierten Modulators und über den Widerstand R2 an der das Bezugspotential für den Schaltkreis führenden Anschlußklemme 5.

Die Anschlußklemmen 3 und 4 bzw. die bezüglich der das Bezugspotential führenden Klemme 5 symmetrisch liegenden Klemmen 7 und 6 des integrierten Modulatorbausteins bilden die Eingänge für den aktiven Oszillatorteil 1. Durch eine Außenbeschaltung mit passiven Kreisen werden in Verbindung mit dem aktiven Oszillatorkreis 1 im Prinzip LC-Schwingkreise gebildet, die eine definierte Oszillatorfrequenz besitzen. Die an den Klemmen 3 und 4 bzw. 7 und 6 angeschlossenen frequenzbestimmenden passiven Kreise können sowohl symmetrisch als auch asymmetrisch bezüglich der das Bezugspotential für den integrierten Schaltkreis führenden Klemme 5 angeordnet sein.

Insbesondere für das UHF-Band ist, um für die in einem DIL-Gehäuse befindliche integrierte Modulatorschaltung die erforderlichen Werte für die Übersprechdämpfung zu erreichen, eine vollsymmetrische Schaltung des Oszillatorteils notwendig. Sieht man bei einer symmetrischen Beschaltung für den VHF-Bereich eine Abstimmdiode vor, so kann man die Oszillatorfrequenz mit Hilfe der Abstimmdiode beispielsweise auf zwei Kanäle des VHF-Bandes abstimmen.

Andererseits ist im VHF-Bereich die Übersprechdämpfung des DIL-Gehäuses ausreichend groß, so daß eine vollsymmetrische Beschaltung nicht notwendig, sondern auch eine asymmetrische Beschaltung möglich ist. Insbesondere lassen sich durch eine Umschaltung zwischen den an den Eingangsklemmen 3 und 4 bzw. 7 und 6 des aktiven Oszillatorteils 1 liegenden Kreisen zwei getrennte Eintaktoszillatoren aufbauen, so daß Abstimm- bzw. Schaltdioden entfallen können. Zweckmäßigerweise liegt dabei entweder die Klemme 4 oder die Klemme 6 über je einen zugehörigen Widerstand an der die positive Versorgungsspannung führenden Klemme 8 des integrieten Bausteins, wobei jeweils entweder die Klemme 3 oder die Klemme 7 durch mindestens einen Kondensator gegenüber der Versorgungsspannung abgeblockt wird. Bei Anschluß der Klemme 4 an die positive Versorgungsspannung sind die Oszillatoreingänge 6 und 7, bei Anschluß der Klemme 6 an die positive Versorgungsspannung sind die Oszillatoreingänge 3 und 4 des integrierten Schaltkreises aktiv. Durch geeignete Wahl der den Klemmen 3 und 4 bzw. 6 und 7 zugeordneten passiven Kreise läßt sich die Oszillatorfrequenz auf jeweils einen Kanal des VHF-Bandes abstimmen, und die Schwingungsamplitude des Oszillators so wählen, daß die Übersprechdämpfung des unsymmetrischen Oszillators zu den noch zu beschreibenden Ausgängen 13 bzw. 15 ausreichend groß ist.

Die Ausgänge dieses an sich bekannten Oszillatoraufbaus bilden die Emitter der Transistoren $T1$ bzw. $T2$ des aktiven Oszillatorteils 1 des integrierten Modulatorbausteins, die das Oszillatorsignal über die Koppelkondensatoren $C1$ bzw. $C2$ in die Pufferstufe 10 einkoppeln. Von dieser an sich bekannten Pufferstufe 10 gelangt das Oszillatorsignal an den Eingang einer ebenfalls an sich bekannten Mischerschaltung 11, die weitere Eingangsklemmen 20 und 21 bzw. 22 und 23 besitzt, an denen ein Audio- und/oder Videosignal anliegen kann. Das im Mischer 11 erzeugte Mischsignal aus dem Audio-, Video- und Oszillatorsignal gelangt über eine Radiofrequenz- Ausgangspufferstufe 12, die ebenfalls an sich bekannt ist, an die Ausgangsklemmen 13 und 15 des integrierten Modulatorbausteins und läßt sich zwischen diesen Klemmen 13 bzw. 15 und der das Bezugspotential des Modulatorbausteins führenden Klemme 14 abgreifen.

Der vorliegenden Erfindung liegt der Gedanke zugrunde, mit nur einem einzigen aktiven Oszillatorkreis 1 und einem einzigen Mischer 11 den Schaltungsaufwand gering zu halten und die für UHF-Betrieb notwendige hohe Übersprechdämpfung durch eine rückwirkungsfreie Einkopplung des Oszillatorsignals in den Mischer 11 zu erreichen. Dazu dient die an sich bekannte Pufferstufe 10, die im wesentlichen einen Differenzverstärker und vorgeschaltete, den Eingang bildende Emitterfolger enthält, in die das Ausgangssignal der Oszillatortransistoren $T1$ und $T2$ über die Koppelkondensatoren $C1$ und $C2$ eingespeist wird und deren Ausgang an den Mischereingang angekoppelt ist.

Die Oszillatortransistoren $T1$ und $T2$ werden sowohl im symmetrischen UHF-Betrieb als auch im VHF-Band im asymmetrischen Betrieb zur Ansteuerung der Pufferstufe 10 bzw. der Mischerschaltung 11 eingesetzt. Im unsymmetrischen VHF-Betrieb ermöglichen die Koppelkondensatoren $C1$ oder $C2$ die Einkopplung des Oszillatorsignals in die Pufferstufe 10, die für eine Symmetrierung des Signals zur Mischeransteuerung sorgt. Video- und tonfrequente Signale werden durch die Pufferstufe 10 sowie durch die als Hochpaß wirkenden Kondensatoren $C1$ und $C2$ ausreichend unterdrückt, so daß die im aktiven Oszillatorteil 1 als Verstärker wirkenden Transistoren $T1$ und $T2$ minimale Störungen im Schwingbetrieb erfahren und der Oszillator mit hoher spektraler Reinheit schwingt. Die Entkopplung vom Mischer 11 zum Oszillatorteil 1 im aktiven Signalweg ist bei der erfindungsgemäßen Schaltung ausreichend groß. Um hohe Rückwirkungsfreiheit vom Audio-bzw. Videosignal auf den Oszillator über den parasitäten Weg, wie er durch das DIL-Gehäuse und das gemeinsame Substrat gegeben ist, zu gewährleisten, ist es erforderlich, möglichst kleine Kapazitätswerke des parasitäten Substratanteils der Koppelkondensatoren $C1$ und $C2$ zu erhalten.

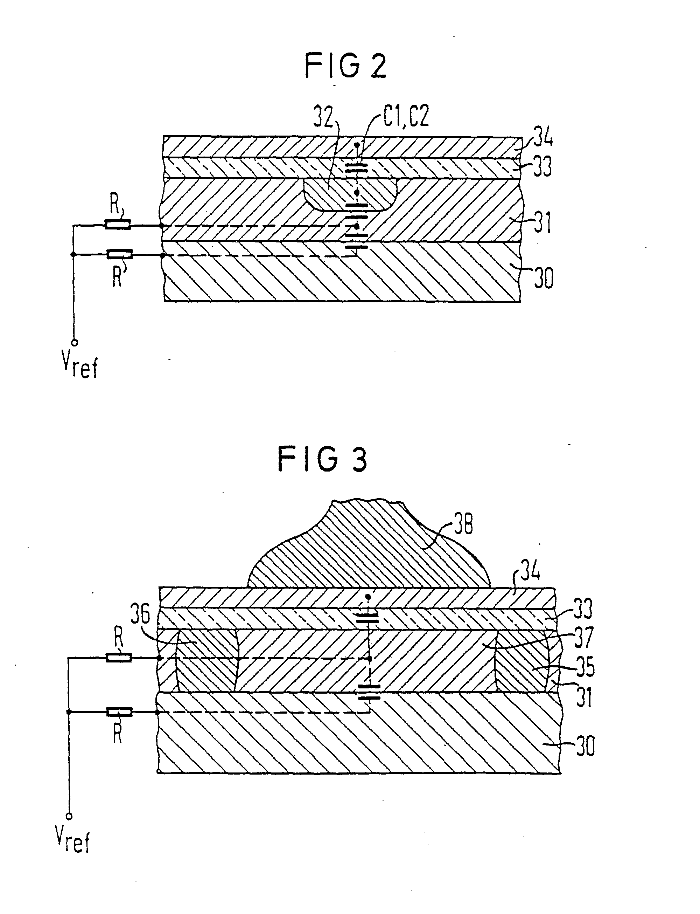

Fig. 2 zeigt ein Ausführungsbeispiel einer erfindungsgemäßen Anordnung der Koppelkondensatoren $C1$ und $C2$. Auf das Substrat 30 ist eine epitaktische Schicht 31 aufgebracht, die eine durch Diffusion oder Implantation erhaltene Zone 32 enthält, die hochleitend ist. Über der epitaktischen Schicht 31 und der hochleitenden Zone 32 schließt sich eine als Dielektrikum dienende, aus isolierendem und passivierendem Material, z. B. $SiO_2$ bestehende Schicht 33 an, über der eine hochleitende Schicht 34 liegt, die beispielsweise aus Aluminium besteht. Eine Koppelkapazität $C1$ bzw. $C2$ ist durch die MOS-Kapazität gebildet, die bei Vernachlässigung von Randeffekten durch die geometrischen Abmessungen der der isolierenden Schicht 33 zugewandten Oberfläche der leitenden Zone 32 als einer Elektrode und eine gleichgroße Fläche der leitenden Schicht 34 als zweiter Elektrode sowie dem dazwischen liegenden Dielektrikum der isolierenden Schicht 33 gegeben ist.

Da das Substrat 30 und die leitende Zone 32 vom gleichen Leitfähigkeitstyp sind, während die epitaktische Schicht 31 vom anderen Leitfähigkeitstyp ist, enthält die erfindungsgemäße Anordnung nach Fig. 2 an den Sperrschichten vom Substrat 30 zur epitaktischen Schicht 31 und von der epitaktischen Schicht 31 zur leitenden Zone 32 parasitäre Kapazitäten. Erfindungsgemäß ist die als Leiterbahn ausgebildete leitfähige Schicht 34 mit dem Ausgang der Transistoren $T1$ bzw. $T2$ des Oszillators und die hochleitende Zone 32 mit dem Eingang der Pufferstufe 10 verbunden. Weiterhin liegen das Substrat 30 und die epitaktische Schicht 31 erfindungsgemäß über einen hochohmigen Zweig R an einem Referenzpotential $V_{ref}$.

Die parasitären Substratanteile der Koppelkondensatoren $C1$ bzw. $C2$ sind damit durch eine Serienschaltung zweier parasitärer Kapazitäten, nämlich der Sperrschichtkapazität zwischen dem Substrat 30 und der epitaktischen Schicht 31 einerseits und der epitaktischen Schicht 31 und der hochleitenden Zone 32 andererseits gebildet, die hochohmig an einem Referenzpotential $V_{ref}$ liegen. Gleichzeitig sind diese parasitären Kapazitäten auf die dem Oszillatorausgang, d. h. den Emittern der Transistoren $T1$ und $T2$ abgewandte Seite der Koppelkondensatoren $C1$ und $C2$ gelegt. Während somit das Oszillatorausgangssignal nach dem Passieren der Koppelkapazitäten $C1$ und $C2$ eine Parallelschaltung der als eine einzige parasitäre Kapazität aufzufassenden Serienschaltung der oben definierten parasitären Kapazitäten und der Eingangskapazität der Pufferstufe 10 sieht, bleibt ein möglicherweise von dem Mischer 11 über das Substrat 30 rückgekoppeltes Signal, das über die Serienschaltung der parasitären Kapzitäten zwischen dem Substrat 30 und der epitaktischen Schicht 31, der epitaktischen Schicht 31 und der hochleitenden Zone 32 und der Koppelkapazitäten C1 bzw. C2 an den Ausgang des Oszillators gelangen könnte, ausreichend klein, so daß es ohne Einfluß auf die Oszillatorfrequenz bleibt. Da andererseits das Substrat 30 und die epitaktische Schicht 31 hochohmig über R an einem Referenzpotential $V_{ref}$ liegen, bleiben mögliche langsame Ladungsträgerbewegungen in diesen Schichten ebenfalls ohne Einfluß auf die Oszillatorfrequenz. Um über das Substrat 30 auf die Anschlüsse 3 und 4 bzw. 6 und 7 zwischen dem aktiven Oszillatorteil 1 und den frequenzbestimmenden passiven Kreisen rückgekoppelte parasitäre Signale, die auf die Oszillatorfrequenz einwirken können, zu eliminieren, werden die Oszillatoranschlüsse 3 und 4 bzw. 6 und 7 und die Modulatorausgangsanschlüsse 13 und 15 durch eine in Fig. 3 als Ausführungsbeispiel dargestellte Struktur gebildet. In einer auf dem Substrat 30 aufgebrachten epitaktischen Schicht 31 befinden sich Isolations-Diffusionszonen 35 und 36, die eine Wanne 37 einschließen. Über dem Halbleiterkörper liegt eine isolierende und passivierende Schicht 33, über der eine hochleitende Schicht 34, z. B. aus Aluminium liegt. Auf der leitenden Schicht 34 werden die Chipanschlüsse 38, z. B. durch Thermokompression hergestellt, die ihrerseits zu dem Gehäuseanschluß der integrierten Schaltung führen. Die durch das Substrat 30 vom einen Leitfähigkeitstyp und die Wanne 37 vom anderen Leitfähigkeitstyp gebildete Sperrschichtkapazität bildet in diesem Fall zusammen mit der zwischen der Wanne 37 und der leitenden Schicht 34 gebildeten MOS-Kapazität eine parasitäre Kapazität, die möglichst ohne Einfluß auf den Oszillatorkreis bleiben soll. Erfindungsgemäß wird deshalb die aus der epitaktischen Schicht 37 gebildete Wanne ebenfalls hochohmig über R an ein Referenzpotential $V_{ref}$ gelegt, so daß sich eine Serienschaltung der beiden parasitären Kapazitäten ergibt, die zu einer gegenüber der Sperrschichtkapazität oder der MOS-Kapazität erheblich geringeren Ersatzkapazität führt. Gleichzeitig werden durch mögliche Ladungsträgerbewegungen in der Wanne 37 gegebene Einflüsse auf die Oszillatorfrequenz vermieden.

**Patentansprüche**

1. Oszillator- und Mischerschaltung eines integrierten UHF/VHF-Modulatorschaltkreises, bei der ein aktiver Oszillatorkreis (1) durch eine Beschaltung mit frequenzbestimmenden passiven Kreisen für UHF- und Mehrkanal-VHF-Betrieb auslegbar ist, bei welcher der Mischerteil (11) zur Mischung des Oszillatorsignals und eines Nutzsignals, insbesondere eines Video- und/oder Audiosignals dient, und bei der ein einziger aktiver Oszillatorkreis (1) rückwirkungsfrei mit einem einzigen Mischer (11) gekoppelt ist, dadurch gekennzeichnet, daß

a) als kapazitive rückwirkungsfreie Kopplung eine integrierte Kapazitätsanordnung vorgesehen ist, die durch die Reihenschaltung einer MOS-Kapazität (C1, C2) und einer Sperrschicht-Kapazität gebildet ist,

b) die MOS-Kapazität (C1, C2) durch den die integrierte Schaltung enthaltenden Halbleiterkörper, eine Isolations-Passivierungsschicht (33) auf dem Halbleiterkörper als Dielektrikum und eine auf der Isolations-Passivierungsschicht (33) verlaufende Leiterbahn (34) gebildet ist und

c) die Sperrschichtkapazität durch mindestens einen pn-Übergang gebildet ist, der zwischen einer im Halbleiterkörper der integrierten Schaltung liegenden dotierten Zone (30, 31, 32 ; 30, 37) gebildet ist.

2. Modulatorschaltung nach Anspruch 1, dadurch gekennzeichnet, daß die rückwirkungsfreie Kopplung zwischen aktivem Oszillatorkreis (1) und Mischer (11) über eine Pufferstufe (10) vorgenommen ist, deren Eingang kapazitiv rückwirkungsfrei an den Ausgang des aktiven Oszillatorkreises (1) und deren Ausgang an den Eingang des Mischers (11) angekoppelt ist.

3. Modulatorschaltung nach Anspruch 1 oder 2, dadurch gekennzeichnet, daß Anschlüsse (3, 4, 6, 7) zwischen dem aktiven Oszillatorkreis (1) und den frequenzbestimmenden passiven Kreisen und Ausgangsanschlüsse (13, 15) des Mischerkreises (11, 12) durch eine Kapazitätsanordnung nach Merkmal c) des Anspruches 1 gebildet sind.

4. Modulatorschaltung nach einem der Ansprüche 1 bis 3, dadurch gekennzeichnet, daß die Sperrschichtkapazität über einen hochohmigen Zweig (R) an einem Referenzpotential ($V_{ref}$) liegt.

**Claims**

1. Oscillator and mixer circuit of an integrated UHF/VHF modulator circuit in which an active oscillator circuit (1) can be designed for UHF and multi-channel VHF operation by connecting to it frequency-determining passive circuits, in which the mixer section (11) is used for mixing the oscillator signal and a useful signal, particularly a video and/or audio signal, and in which a single active oscillator circuit (1) is non-reactively coupled to a single mixer (11), characterized in that

a) an integrated capacitance arrangement, which is formed by the series-connection of an MOS capacitance (C1, C2) and a barrier-layer capacitance, is provided as capacitive non-reactive coupling,

b) the MOS capacitance (C1, C2) is formed by the semiconductor body containing the integrated circuit, an insulation passivation layer (33) on the semiconductor body as dielectric and a conductor track (34) extending on the insulation passivation layer (33), and

c) the barrier layer capacitance is formed by at least one pn junction which is formed within a doped zone (30, 31, 32 ; 30, 37) located in the semiconductor body of the integrated circuit.

2. Modulator circuit according to Claim 1, characterized in that the non-reactive coupling between active oscillator circuit (1) and mixer (11) is carried out via a buffer stage (10), the input of which is capacitively non-reactively coupled to the output of the active oscillator circuit (1) and the output of which is coupled to the input of the mixer (11).

3. Modulator circuit according to Claim 1 or 2, characterized in that connections (3, 4, 6, 7) between the active oscillator circuit (1) and the frequency-determining passive circuits and output connections (13, 15) of the mixer circuit (11, 12) are formed by a capacitance arrangement according to feature c) of Claim 1.

4. Modulator circuit according to one of Claims 1 to 3, characterized in that the barrier layer capacitance is connected via a high-resistance branch (R) to a reference potential ($V_{ref}$).

## Revendications

1. Circuit oscillateur et mélangeur d'un circuit modulateur intégré UHF/VHF, dans lequel un circuit oscillateur actif (1) est conçu pour être raccordé à des circuits passifs, qui déterminent la fréquence, pour le fonctionnement UHF et le fonctionnement VHF à canaux multiples, et dans lequel la partie formant mélangeur (11) sert à mélanger le signal de l'oscillateur et un signal utile, notamment un signal vidéo et/ou un signal audio, et dans lequel un seul circuit oscillateur actif (1) est accouplé sans réaction à un seul mélangeur (11), caractérisé par le fait que

a) comme couplage capacitif sans réaction, il est prévu un dispositif capacitif intégré, formé par le montage série d'une capacité MOS (C1, C2) et d'une capacité de la couche d'arrêt,

b) la capacité MOS (C1, C2) est formée par le corps semiconducteur qui contient le circuit intégré, par une couche d'isolation et de passivation (33) située sur le corps semiconducteur et formant diélectrique, et par une voie conductrice (34) s'étendant sur la couche d'isolation et de passivation (33), et

c) la capacité de la couche d'arrêt est formée par au moins une jonction pn, qui est formée entre les zones dopées (30, 31 ; 32 ; 30, 37) situées dans le corps semiconducteur du circuit intégré.

2. Circuit modulateur suivant la revendication 1, caractérisé par le fait que le couplage sans réaction entre le circuit oscillateur actif (1) et le mélangeur (11) est réalisé au moyen d'un étage tampon (10), dont l'entrée est accouplée de façon capacitive et sans réaction à la sortie du circuit oscillateur actif (1) et dont la sortie est accouplée à l'entrée du mélangeur (11).

3. Circuit modulateur suivant la revendication 1 ou 2, caractérisé par le fait que des connexions (3, 4, 6, 7) entre le circuit oscillateur actif (1) et les circuits passifs, qui déterminent la fréquence, et des bornes de sortie (13, 15) du circuit mélangeur (11, 12) sont formées par un dispositif capacitif conformément à la caractéristique c) de la revendication 1.

4. Circuit modulateur suivant l'une des revendications 1 à 3, caractérisé par le fait que la capacité de la couche d'arrêt est placée, par l'intermédiaire d'une branche (R) de forte valeur ohmique, à un potentiel de référence ($V_{ref}$).

# FIG 1

# FIG 2

# FIG 3